# EUROPÄISCHE PATENTSCHRIFT

(11) **EP 3 379 581 B1**
(45) Veröffentlichungstag und Bekanntmachung des Hinweises auf die Patenterteilung: **17.07.2019**
(21) Anmeldenummer: 18000268.5
(22) Anmeldetag: 19.03.2018
(51) Int. Cl.: H01L 29/861, H01L 29/20, H01L 29/32, H01L 29/36, H01L 21/329, H01L 29/872

(54) **III-V-HALBLEITERDIODE AUF GAAS BASIS**
GAAS-BASED III-V SEMICONDUCTOR DIODE
DIODE SEMI-CONDUCTRICE III-V À BASE DE GAAS

(30) Priorität: 24.03.2017 DE 102017002936
(43) Veröffentlichungstag der Anmeldung: 26.09.2018
(60) Teilanmeldung: 19000270.9
(73) Patentinhaber: 3-5 Power Electronics GmbH, 01217 Dresden (DE)
(72) Erfinder: Volker, Dudek, 76275 Ettlingen (DE)
(74) Vertreter: Koch Müller Patentanwaltsgesellschaft mbH

(56) Entgegenhaltungen:
- DE-A1-102014 223 315
- US-A- 5 733 815
- US-A1- 2006 281 263
- YU SOLDATENKOV F ET AL: "GaAs- ABheterostructures for high-speed power diodes manufacturing", JOURNAL OF PHYSICS: CONFERENCE SERIES, INSTITUTE OF PHYSICS PUBLISHING, BRISTOL, GB, Bd. 661, Nr. 1, 2. Dezember 2015 (2015-12-02), Seite 12066, XP020290808, ISSN: 1742-6596, DOI: 10.1088/1742-6596/661/1/012066 [gefunden am 2015-12-02]
- G Ashkinaw ET AL: "Solid-State Ekch~~ies PROCESS AND DEVICE CHARACTERIZATION OF HIGH VOLTAGE GALLIUM ARSENIDE P-i-N LAYERS GROWN BY AN IMPROVED LIQUID PHASE EPITAXY METHOD", , 1. Januar 1993 (1993-01-01), Seiten 1749-1755, XP055498521, Gefunden im Internet: URL:https://ac.els-cdn.com/003811019390222 C/1-s2.0-003811019390222C-main.pdf?_tid=72 33ad54-efe8-4ea2-88c8-5e338494f1ea&acdnat= 1533743034_2745cb1569513a6a36b78720a87bc23 6

## Beschreibung

Die Erfindung betrifft eine III-V-Halbleiterdlode.

Aus "GaAs Power Devices" von German Ashkinazi, ISBN 965-7094-19-4, Seite 8 und 9 ist eine hochspannungsfeste Halbleiterdiode p⁺ - n - n⁺ bekannt. Es ist wünschenswert, dass hochspannungsfeste Halbleiterdioden neben der hohen Spannungsfestigkeit sowohl niedrige Durchschaltwiderstände als auch geringe Leckströme im Sperrbereich aufweisen.

GaAs-basierte, hochspannungsfeste Halbleiterdioden sind auch aus "GaAs- A3B5 heterostructures for high-speed power diodes manufacturing", Soldatenkov et Al., Journal of Physics: Conference Series 661 (2015), aus "PROCESS AND DEVICE CHARACTERIZATION OF HIGH VOLTAGE GALLIUM ARSENIDE P-i-N LAYERS GROWN BY AN IMPROVED LIQUID PHASE EPITAXY METHOD", Ashkinazio et AI., Solid-State Electronics Vol. 36, No. 12, pp. 1749-1755, 1993 und aus der US 5,733,815 bekannt.

Ausserdem offenbart die US 2006/0281263 eine hochspannungsfeste Halbleiterdiode, die eine Defektschicht in der n Driftschicht aufweist und die aus GaAs bestehen kann.

Vor diesem Hintergrund besteht die Aufgabe der Erfindung darin, eine Vorrichtung anzugeben, die den Stand der Technik weiterbildet.

Die Aufgabe wird durch eine III-V-Halbleiterdiode mit den Merkmalen des Patentanspruchs 1 gelöst. Vorteilhafte Ausgestaltungen der Erfindung sind Gegenstand von Unteransprüchen.

Gemäß dem Gegenstand der Erfindung wird eine stapelförmige III-V-Halbleiterdiode bereitgestellt, aufweisend eine n⁺-Schicht, eine n⁻-Schicht sowie eine p⁺-Schicht.

Die n⁺-Schicht weist eine Oberseite, eine Unterseite, eine Dotierstoffkonzentration von mindestens 10¹⁹ N/cm3 und eine Schichtdicke zwischen 10 µm und 675 µm, vorzugsweise zwischen 50 µm und 400 µm auf, wobei das n⁺-Substrat eine GaAs-Verbindung umfasst oder aus einer GaAs Verbindung besteht.

Die n⁻-Schicht weist eine Oberseite, eine Unterseite, eine Dotierstoffkonzentration von 10¹²-10¹⁶ N/cm3 und eine Schichtdicke von 10-300 µm auf und umfasst eine GaAs-Verbindung oder besteht aus einer GaAs Verbindung.

Die p⁺-Schicht mit einer Oberseite, einer Unterseite, einer Dotierstoffkonzentration von 5•10¹⁸-5•10²⁰ N/cm3 und eine Schichtdicke zwischen 0,5 µm und 50 µm umfasst oder besteht aus einer GaAs Verbindung.

Die Schichten folgen in der genannten Reihenfolge aufeinander und sind monolithisch ausgebildet, wobei die n⁺-Schicht oder die p⁺-Schicht als Substrat ausgebildet ist und die Unterseite der n⁻-Schicht stoffschlüssig mit der Oberseite der n⁺-Schicht verbunden ist.

Zwischen der n⁻-Schicht und der p⁺-Schicht ist eine dotierte Zwischenschicht mit einer Schichtdicke von 1-50 µm und einer Dotierstoffkonzentration von 10¹²-10¹⁷ cm⁻³ angeordnet mit einer Oberseite und einer Unterseite, wobei die Unterseite der Zwischenschicht mit der Oberselte der n⁻-Schicht stoffschlüssig verbunden ist und die Oberseite der Zwischenschicht mit der Unterseite der p⁺-Schicht stoffschlüssig verbunden ist.

Die Zwischenschicht ist mit der n⁻-Schicht und mit der p⁺-Schicht stoffschlüssig verbunden und p-dotiert.

Die stapelförmige III-V-Halbleiterdiode umfasst außerdem eine erste Defektschicht. Die erste Defektschicht weist eine Schichtdicke zwischen 0,5 µm und 40 µm auf, wobei die Defektschicht innerhalb der p-dotierten Zwischenschicht angeordnet ist und die Defektschicht eine Defektkonzentration im einem Bereich zwischen 1•10¹⁴ N/ cm³ und 5•10¹⁷ N/cm³ aufweist. Im Folgenden werden die Begriffe Zwischenschicht und p-Schicht synonym verwendet.

Es sei angemerkt, dass die Schichten mittels einer Flüssigphasenepitaxie oder mittels einer MOVPE Anlage hergestellt werden.

Es versteht sich, dass die Defektschicht sich auf unterschiedliche Weise, beispielsweise durch Implantation oder mittels Einbau von Fremdatomen erzeugen lässt und innerhalb der Defektschicht eine Rekombination von Ladungsträger erreicht wird.

Auch sei angemerkt, dass die Defektschicht möglichst nicht innerhalb der Raumladungszone ausgebildet ist. Vorzugsweise ist die Dicke der p-Schicht derart ausgebildet, so dass die Defektschicht von der Raumladungszone beabstandet ist.

Ein Vorteil ist, dass sich mittels des Einbaus der Defektschicht die Höhe der Leckströme im Sperrbereich reduzieren lässt, während im Durchlassbereich sich die Bauelementeeigenschaften nahezu unbeeinflusst sind. Insbesondere im Sperrbereich bei Spannung oberhalb 1000V machen sich Leckströme nachteilig bemerkbar.

Ferner steigen die Leckströme mit der Temperatur stark an. Durch den Einbau der Defektschicht lassen sich die Leckströme um mehr als eine Größenordnung gegenüber Dioden ohne Defektschicht reduzieren. Des Weiteren wird der Herstellungsprozess wesentlich robuster, d.h. unempfindlich gegen eine hohe Hintergrunddotierung.

Ein weiterer Vorteil Ist, dass sich mit der erfindungsgemäßen III-V-Halbleiterdiode auf einfache Weise niedrige Leckströme bei Sperrspannungen in einem Bereich von 200V - 3300 V mit kleineren Einschaltwiderständen und geringeren Kapazitäten pro Fläche als herkömmliche hochsperrende Dioden aus Si oder aus SiC herstellen lassen. Hierdurch sind Schaltfrequenzen von 30 kHz bis zu 0,5 GHz und Stromdichten von 0,5 A/mm² bis 5 A/mm² erreichbar.

Ein anderer Vorteil ist, dass sich die III-V-Halbleiterdioden kostengünstiger als vergleichbare hochsperrende Dioden aus SiC herstellen lassen.

Insbesondere lassen sich die erfindungsgemäßen III-V-Halbleiterdioden als Freilaufdioden verwenden.

Es sei angemerkt, dass die erfindungsgemäßen III-V-Halbleiterdioden vorliegend kleine Einschaltwiderstände in einem Bereich zwischen 1 mOhm und 200 mOhm aufweisen. Die Kapazitäten pro Fläche liegen in einem Bereich zwischen 2 pF und 100 pF.

Ein anderer Vorteil der erfindungsgemäßen III-V-Halbleiterdiode ist eine hohe Temperaturfestigkeit von bis zu 300°C. Anders ausgedrückt lassen sich die III-V-Halbleiterdioden auch in heißen Umgebungen einsetzten. Hierbei sind niedrige Leckströme aufgrund des exponentiellen Anstiegs mit steigender Temperatur besonders hilfreich.

In einer ersten Ausführungsform weist die erste Defektschicht einen Abstand zu der Unterseite der p⁻-Schicht von mindestens der Hälfte der Schichtdicke der p-Schicht auf.

Gemäß einer Weiterbildung weist die Halbleiterdiode eine zweite Defektschicht auf, wobei die zweite Defektschicht eine Schichtdicke in einem Bereich zwischen 0,5 µm und 40 µm, vorzugsweise in einem Bereich zwischen 0,5 und 40 µm und eine Defektkonzentration im einem Bereich zwischen 1•10¹³N/ cm³ und 5•10¹⁶ N/cm³ aufweist und einen Abstand zu der Oberseite der p-Schicht von höchstens der Hälfte der Schichtdicke der p-Schicht aufweist. Vorzugsweise unterscheidet sich die Defektkonzentration der ersten Defektschicht von der zweiten Defektschicht.

In einer weiteren Ausführungsform weist die erste Defektschicht und/oder eine zweite Defektschicht mindestens einen ersten Schichtbereich mit einer ersten Defektkonzentration und einen zweiten Schichtbereich mit einer zweiten Defektkonzentration auf und folgt insbesondere über die Schichtdicke der ersten Defektschicht und/oder einer zweiten Defektschicht einer statistischen vorzugsweise Gauß-Verteilung. Anders ausgedrückt ist die Defektkonzentration entlang der Dicke der Defektschicht unterschiedlich.

Gemäß einer anderen Ausführungsform umfassen die erste Defektschicht und / oder die zweite Defektschicht Cr und/oder Indium und/oder Aluminium. Vorzugsweise wird Cr während des Epitaxieprozesses in die n⁻-Schicht eingebaut. Ein Vorteil des Einbaus von Cr ist, dass mittels der Konzentration von Cr sich die Anzahl der Störstellen und hierdurch die Anzahl der Rekombinationszentren kostengünstig und auf einfache Weise einstellen lässt, ohne dass der Epitaxieprozess unterbrochen wird.

In einer anderen Ausführungsform sind in der ersten Defektschicht und / oder in der zweiten Defektschicht die Störstellen durch eine Implantation von Atomen oder Molekülen oder durch eine Elektronenstrahl-Bestrahlung erzeugt. Vorzugsweise wird zur Erzeugung von Störstellen H₂ Moleküle mit der entsprechenden Energie und Dosis verwendet.

Gemäß einer weiteren Ausführungsform beträgt eine Gesamthöhe des stapelförmigen Schichtaufbaus bestehend aus der p⁺-Schicht, der p-dotierten Zwischenschicht, der n⁻-Schicht und der n⁺-Schicht zwischen 150-800 µm.

Gemäß alternativer Ausführungsformen weist der stapelförmige Schichtaufbau bestehend aus der p⁺-Schicht, der p-dotierten Zwischenschicht, der n⁻-Schicht und der n⁺-Schicht eine rechteckige oder quadratische Oberfläche mit Kantenlängen zwischen 1 mm und 10 mm oder eine runde, vorzugsweise ovale oder kreisförmige Oberfläche auf.

Gemäß einer weiteren Ausführungsform ist die p⁺-Schicht der Halbleiterdiode durch eine Anschlusskontaktschicht ersetzt, wobei die Anschlusskontaktschicht ein Metall oder eine metallische Verbindung umfasst oder aus einem Metall oder einer metallischen Verbindung besteht und einen Schottky-Kontakt ausbildet.

In einer nicht erfindungsgemäßen Ausführungsform umfasst die III-V Halbleiterdiode wenigstens einen Halbleiterbond.

Es wird angemerkt, dass der Ausdruck Halbleiterbond synonym mit dem Ausdruck Waferbond verwendet wird.

In einer weiteren nicht erfindungsgemäßen Ausführungsform ist der Halbleiterbond bei dem stapelförmigen Schichtaufbau, bestehend aus dem p⁺-Schicht, der p-dotierten Zwischenschicht, der n⁻-Schicht und der n⁺-Schicht, zwischen der n⁻-Schicht und der p-dotierten Zwischenschicht ausgebildet.

In einer nicht erfindungsgemäßen Ausführungsform bildet der Schichtaufbau bestehend aus einem p⁺-Schicht und der p-dotierten Zwischenschicht einen ersten Teilstapel und der Schichtaufbau bestehend aus der n⁺-Schicht und der n⁻-Schicht einen zweiten Teilstapel.

In einer nicht erfindungsgemäßen Weiterbildung wird der erste Teilstapel gebildet, in dem ausgehend von einem p⁺-Schicht mittels Epitaxie die p-dotierten Zwischenschicht hergestellt wird.

Vorzugsweise weist die als p⁻-Schicht ausgebildete Zwischenschicht eine Dotierung kleiner als 10¹³ N/cm⁻³ oder eine Dotierung zwischen 10¹³ N/cm⁻³ und 10¹⁵ N/cm⁻³ auf. In einer Ausführungsform wird das p⁺-Schicht vor oder nach dem Bonden durch einen Schleifprozess auf eine Dicke zwischen 200 µm und 500 µm gedünnt.

In einer nicht erfindungsgemäßen Weiterbildung sind der erste Teilstapel und der zweite Teilstapel jeweils monolithisch ausgebildet.

In einer nicht erfindungsgemäßen Ausführungsform wird der zweite Stapel gebildet, in dem ausgehend von einem n⁻-Substrat, das n⁻-Substrat mit dem zweiten Stapel durch einen weiteren Waferbondprozess verbunden wird.

In einem weiteren Prozessschritt wird das n⁻-Substrat auf die gewünschte Dicke gedünnt. Vorzugsweise liegt die Dicke des n⁻-Substrats in einem Bereich zwischen 50 µm bis 250µm. Vorzugsweise liegt die Dotierung des n⁻-Substrats in einem Bereich zwischen 10¹³ N/cm⁻³ und 10¹⁵ N/cm⁻³.

Ein Vorteil des Waferbondens ist es, dass sich dicke n⁻-Schichten ohne weiteres herstellen lassen. Ein langer Abscheideprozess bei der Epitaxie entfällt hierdurch. Auch lassen sich mittels des Bondens die Anzahl der Stapelfehler bei den dicken n⁻-Schichten verringern.

In einer anderen nicht erfindungsgemäßen Weiterbildung wird vor dem Bonden die Defektschicht vorzugsweise mittels Implantation von Ionen in die Oberfläche des ersten Teilstapels, d.h. in die p-dotierten Zwischenschicht erzeugt.

In eine alternativen nicht erfindungsgemäßen Ausführungsform weist das n⁻-Substrat eine Dotierung größer als 10¹⁰ N/cm⁻³ und kleiner als 10¹³ N/cm⁻³ auf. In dem die Dotierung extrem gering ist, lässt sich das n⁻-Substrat auch als eine intrinsische Schicht auffassen.

In einer nicht erfindungsgemäßen Weiterbildung wird nach dem Dünnen des n⁻-Substrats mittels Epitaxie oder Hochdosisimplantation auf dem n⁻-Substrat die n⁺-Schicht in einem Bereich zwischen 10¹⁸ N/cm⁻³ und kleiner als 5x10¹⁹ N/cm⁻³ erzeugt.

Es versteht sich, dass das Dünnen des n⁻-Substrats vorzugsweise mittels eines CMP Schrittes, d.h. mittels chemischen mechanischen Polierens erfolgt.

In einer anderen Weiterbildung wird auf der Vorderseite der Dioden-Struktur eine Hilfsschicht aufgetragen. Anschließend lässt die Rückseite der Dioden-Struktur dünnen und auf einem Träger ablegen. In einer anderen Weiterbildung wird anschließend die Hilfsschicht von der Vorderseite abgelöst.

In einer Ausführungsform werden die Oberfläche des n⁺-Substrats und die Oberfläche des p⁺-Schichts metallisiert, um die Halbleiter-Diode elektrisch anzuschließen. Vorzugsweise wird die Kathode der Halbleiter-Diode nach der Metallisierung mit einer als Wärmesenke ausgebildeten Unterlage stoffschlüssig verbunden. Anders ausgedrückt, die Anode ist an der Oberfläche der Diode auf der p+-Schicht ausgebildet.

Untersuchungen haben gezeigt, dass sich mit bestimmten Kombinationen von der p⁻- Zwischenschicht und der n⁻-Schicht verschiedene Sperrspannungen erzielen lassen.

In einer ersten Variante umfasst die:
p⁻- Zwischenschicht eine Dicke zwischen 10 µm bis 25 µm und die n⁻-Schicht eine Dicke zwischen 40 µm und 90 µm was eine Sperrspannung von ca. 900 V ergibt.

In einer zweiten Variante umfasst die:
p⁻- Zwischenschicht eine Dicke zwischen 25 µm bis 35 µm und die n⁻-Schicht eine Dicke zwischen 40 µm und 70 µm was eine Sperrspannung von ca. 1200 V ergibt.

In einer dritten Variante umfasst die:
p⁻- Zwischenschicht eine Dicke zwischen 35 µm bis 50 µm und die n⁻-Schicht eine Dicke zwischen 70µm und 150 µm was eine Sperrspannung von ca. 1500 V ergibt.

Die Dioden in der ersten bis dritten Variante lassen sich auch als Punsch- Dioden bezeichnen.

In einer vierten Variante umfasst die:
p⁻- Zwischenschicht eine Dicke zwischen 10 µm bis 25 µm und die n⁻-Schicht eine Dicke zwischen 60 µm und 110 µm.

In einer fünften Variante umfasst die:
p⁻- Zwischenschicht eine Dicke zwischen 10 µm bis 25 µm und die n⁻-Schlcht eine Dicke zwischen 70 µm und 140.

In einer sechsten Variante umfasst die:
p⁻- Zwischenschicht eine Dicke zwischen 35 µm bis 50 µm und die n⁻-Schicht eine Dicke zwischen 80µm und 200 µm.

Die Dioden in der vierten bis sechsten Variante lassen sich auch als "non - reach - through" - Dioden bezeichnen.

Die Erfindung wird nachfolgend unter Bezugnahme auf die Zeichnungen näher erläutert. Hierbei werden gleichartige Teile mit identischen Bezeichnungen beschriftet. Die dargestellten Ausführungsformen sind stark schematisiert, d.h. die Abstände und die lateralen und die vertikalen Erstreckungen sind nicht maßstäblich und weisen, sofern nicht anders angegeben, auch keine ableitbaren geometrischen Relationen zueinander auf. Darin zeigen, die:
- Figur 1: eine Ansicht einer ersten erfindungsgemäße Ausführungsform einer III-V-Halbleiterdiode,
- Figur 2: eine Ansicht einer zweiten erfindungsgemäße Ausführungsform einer III-V-Halbleiterdiode,
- Figur 3: eine Aufsicht auf die III-V-Halblelterdiode aus Figur 1 oder aus Figur 2,
- Figur 4: eine Ansicht einer dritte erfindungsgemäße Ausführungsform einer III-V-Halbleiterdiode,
- Figur 5: eine Ansicht einer vierte erfindungsgemäße Ausführungsform einer III-V-Halbleiterdiode.

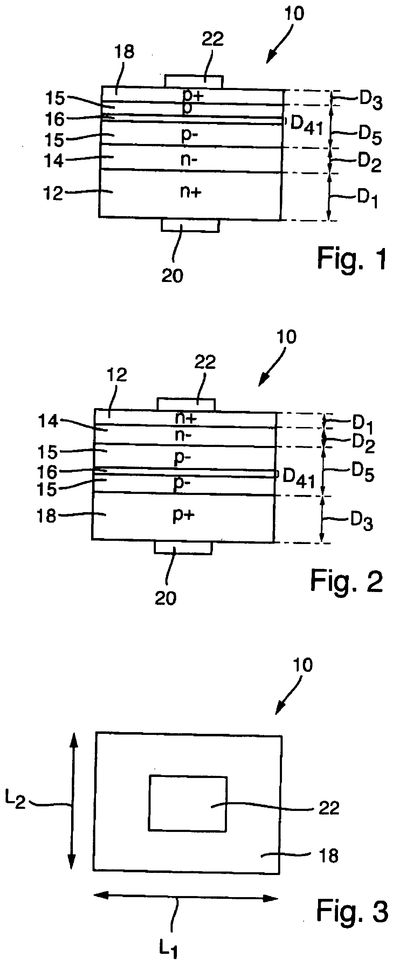

Die Abbildung der Figur 1 zeigt eine Ansicht einer ersten Ausführungsform einer erfindungsgemäßen stapelförmigen III-V-Halbleiterdiode 10, aufweisend eine n⁺-Schicht 12 als ein Substrat, eine mit der n⁺-Schicht 12 stoffschlüssig verbundene niedrig dotierte n⁻-Schicht 14 und eine mit der n⁻-Schicht 14 stoffschlüssig verbundene p-dotierte Zwischenschicht 15 und eine mit der Zwischenschicht stoffschlüssig verbundene p⁺-Schicht 18 sowie einen ersten Kontakt 20 und einen zweiten Kontakt 22. Innerhalb der p-Schicht 15 ist eine erste Defektschicht 16 angeordnet.

Der erste Kontakt 20 ist stoffschlüssig mit einer Unterseite der n⁺-Schicht 12 verbunden, während der zweite Kontakt 22 stoffschlüssig mit einer Oberseite der p⁺-Schicht 18 verbunden ist.

Die n⁺-Schicht 12 ist stark n-dotiert und weist eine Dotierstoffkonzentration von 10¹⁹ N/cm³. Eine Schichtdicke D1 der n⁺-Schicht 12 liegt zwischen 100 µm und 675 µm.

Die n⁻-Schicht 14 ist niedrig n-dotiert mit einer Dotierstoffkonzentration von 10¹²-10¹⁶ N/cm³ und weist eine Schichtdicke D2 von 10-300 µm auf.

Die p-Zwischenschicht 15 ist niedrig p-dotiert mit einer Dotierstoffkonzentration von 10¹²-10¹⁷ N/cm³ und einer Schichtdicke D5 zwischen 1 µm und 50 µm.

Die p⁺-Schicht 18 ist stark p-dotiert mit einer Dotierstoffkonzentration von 10¹⁹ N/cm³ und einer Schichtdicke D3 größer 2 µm.

Die erste Defektschicht 16 weist eine Schichtdicke D41 in einen Bereich zwischen 0,5 µm und 10 µm und eine Defektdichte im einem Bereich zwischen 1•10¹³ N/cm³ und 5•10¹⁶ N/cm³ auf.

In den Abbildungen der Figuren 2 ist eine zweite Ausführungsform einer III-V-Halbleiterdiode dargestellt, wobei der Unterschied zu der Abbildung der Figur 1 darin liegt, dass die p+-Schicht 18 als Substrat ausgebildet ist, auf das die weiteren Schichten folgen.

In der Abbildung der Figuren 3 ist eine Aufsicht auf die in Figur 1 gezeigte erste Ausführungsform einer erfindungsgemäßen III-V-Halbleiterdiode dargestellt. Im Folgenden werden nur die Unterschiede zu der Abbildung der Figur 1 erläutert.

Der stapelförmige Schichtaufbau 100 der III-V-Halbleiterdiode 10 bestehend aus dem n⁺-Substrat 12, der die Defektschicht 16 umfassenden n⁻-Schicht 14 und der p⁺-Schicht 18 weist einen rechteckigen Umfang und damit auch eine rechteckige Oberfläche mit den Kantenlängen L1 und L2 auf. Die auf der Oberfläche der Schichtenfolge 100 angeordnete Kontaktfläche 22 überdeckt nur einen Tell der Oberfläche.

In einer anderen nicht dargestellten Ausführungsform sind die Ecken des stapelförmigen Schichtaufbaus 100 verrundet, um Feldstärkespitzen bei hohen Spannungen zu vermeiden.

In einer anderen nicht dargestellten Ausführungsform ist die Oberfläche des stapelförmigen Schichtaufbaus 100 rund ausgeführt. Hierdurch werden Überhöhungen der Feldstärke besonders effektiv reduziert. Vorzugsweise ist die Oberfläche kreisförmig oder oval ausgeführt.

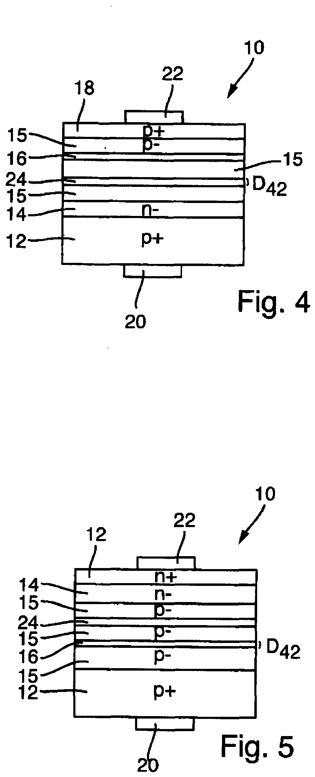

In der Abbildung der Figuren 4 ist eine Weiterbildung der III-V-Halbleiterdiode aus Figur 1 dargestellt, wobei die p-Zwischenschicht 15 der Halbleiterdiode 10 im Unterschied zu der ersten Ausführungsform eine zweite Defektschicht 24 mit einer Dicke 42 aufweist.

Die Schichtdicke D42 der zweiten Defektschicht 24 beträgt zwischen 0,5 µm und 40 µm. Die Defektkonzentration liegt zwischen 1•10¹³ N/cm³ und 5•10¹⁶ N/cm³. Der Abstand zu der Oberseite der p-Schicht weist höchstens die Hälfte der Schichtdicke D5 der Zwischenschicht auf.

In der Abbildung der Figuren 5 Ist eine Weiterbildung der III-V-Halbleiterdiode aus Figur 2 dargestellt, wobei die p-Schicht 15 der Halbleiterdiode 10 im Unterschied zu der zweiten Ausführungsform eine zweite Defektschicht 24 aufweist.

## Patentansprüche

1. Stapelförmige III-V-Halbleiterdiode (10), aufweisend
- eine n⁺-Schicht (12) mit einer ersten Seite, einer der ersten Seite gegenüberliegenden zweiten Seite, einer Dotierstoffkonzentration von mindestens 10¹⁹ N/cm³ und einer Schichtdicke (D1) von 50-675 µm, wobei die n⁺-Schicht (12) eine GaAs-Verbindung umfasst oder aus einer GaAs Verbindung besteht,
- eine n⁻-Schicht (14) mit einer ersten Seite und einer der ersten Seite gegenüberliegenden zweiten Seite, einer Dotierstoffkonzentration von 10¹²-10¹⁶ N/cm³, einer Schichtdicke (D2) von 10-300 µm und eine GaAs-Verbindung umfasst oder aus einer GaAs Verbindung besteht,
- eine p⁺-Schicht (18) mit einer ersten Seite, einer der ersten Seite gegenüberliegenden zweiten Seite, einer Dotierstoffkonzentration von 5•10¹⁸-5•10²⁰ N/cm³, mit einer Schichtdicke (D3) größer 2 µm und eine GaAs-Verbindung umfasst oder aus einer GaAs Verbindung besteht, wobei
- die Schichten in der genannten Reihenfolge aufeinander folgen und monolithisch ausgebildet sind,
- die n⁺-Schicht (12) oder die p⁺-Schicht (18) als Substrat ausgebildet ist und
- die zweite Seite der n⁻-Schicht (14) stoffschlüssig mit der ersten Seite der n⁺-Schicht (12) verbunden ist,
zwischen der n⁻-Schicht (14) und der p⁺-Schicht (18) eine dotierte Zwischenschicht (15) mit einer Schichtdicke (D5) von 1-50 µm und einer Dotierstoffkonzentration von 10¹²-10¹⁷ N/cm³ angeordnet ist, und mit einer ersten Seite und einer der ersten Seite gegenüberliegenden zweiten Seite, und die zweite Seite der Zwischenschicht (15) mit der ersten Seite der n⁻-Schicht (14) stoffschlüssig verbunden ist und die erste Seite der Zwischenschicht mit der zweiten Seite der p⁺-Schicht (18) stoffschlüssig verbunden ist, wobei die Zwischenschicht (15) mit der n⁻-Schicht (14) und mit der p⁺-Schicht (18) stoffschlüssig verbunden und p-dotiert ist,
worin die stapelförmige III-V-Halbleiterdiode (10) eine erste Defektschicht (16) mit einer Schichtdicke (D41) zwischen 0,5 µm und 40 µm aufweist,
- wobei die Defektschicht (16) innerhalb der p-dotierten Zwischenschicht (15) angeordnet ist,
- die Defektschicht (16) eine Defektkonzentration im einem Bereich zwischen 1•10¹³ N/cm³ und 5•10¹⁶ N/cm³ aufweist.

2. III-V-Halbleiterdiode (10) nach Anspruch 1, **dadurch gekennzeichnet**, die erste Defektschicht (16) einen Abstand zu der zweiten Seite der p-dotierten Zwischenschicht (15) von mindestens die Hälfte der Schichtdicke (D5) der p-Schicht (15) aufweist.

3. III-V-Halbleiterdiode (10) nach Anspruch 1 oder 2, **dadurch gekennzeichnet, dass** die Halbleiterdiode (10) eine zweite Defektschicht (24) aufweist, wobei die zweite Defektschicht (24) eine Schichtdicke (D42) zwischen 0,5 µm und 40 µm und eine Defektkonzentration zwischen 1•10¹³ N/cm³ und 5•10¹⁶ N/cm³ aufweist und einen Abstand zu der ersten Seite der p-dotierten Zwischenschicht (15) von höchstens der Hälfte der Schichtdicke (D5) der p-dotierten Zwischenschicht (15) aufweist.

4. III-V-Halbleiterdiode (10) nach einem der Ansprüche 1 bis 2, **dadurch gekennzeichnet, dass** die erste Defektschicht (16) und / oder eine zweite Defektschicht (24) jeweils einen ersten Schichtbereich mit einer ersten Defektkonzentration und einen zweiten Schichtbereich mit einer zweiten Defektkonzentration aufweist.

5. III-V-Halbleiterdiode (10) nach einem der Ansprüche 1 bis 2, **dadurch gekennzeichnet, dass** die Defektkonzentration über die Schichtdicke (D41, D42) der ersten Defektschicht (16) und / oder einer zweiten Defektschicht (24) einer statistischen-Verteilung folgt.

6. III-V-Halbleiterdiode (10) nach einem der Ansprüche 1 bis 5, **dadurch gekennzeichnet, dass** die erste Defektschicht (16) und / oder die zweite Defektschicht (24) wenn diese vorhanden ist Cr und/oder Indium und/oder Aluminium umfasst.

7. III-V-Halbleiterdiode (10) nach einem der Ansprüche 1 bis 6, **dadurch gekennzeichnet, dass** eine Gesamthöhe eines stapelförmigen Schichtaufbaus (100) bestehend aus dem p⁺-Schicht (18), der n⁻-Schicht (14), der p-dotierten Zwischenschicht (15) und der n⁺-Schicht (12) höchstens 150-800 µm beträgt.

8. III-V- Halbleiterdiode (10) nach einem der Ansprüche 1 bis 7, **dadurch gekennzeichnet, dass** der stapelförmige Schichtaufbau (100) bestehend aus dem p⁺-Schicht (18), der n⁻-Schicht (14), der p-dotierten Zwischenschicht (15) und der n⁺-Schicht (12) eine rechteckige oder quadratische Oberfläche mit Kantenlängen (L1, L2) zwischen 1 mm und 10 mm aufweist.

9. III-V- Halbleiterdiode (10) nach einem der Ansprüche 1 bis 7, **dadurch gekennzeichnet, dass** der stapelförmige Schichtaufbau (100) bestehend aus dem p⁺-Schicht (18), der n⁻-Schicht (14), der p-dotierten Zwischenschicht (15) und der n⁺-Schicht (12) eine runde oder ovale oder kreisförmige Oberfläche aufweist.

## Claims

1. Stack-shaped III-V semiconductor diode (10), comprising
- an n⁺ layer (12) with a first side, a second side opposite the first side, a doping substance concentration of at least 10¹⁹ N/cm³ and a layer thickness (D1) of 50 - 675 microns, wherein the n⁺ layer (12) comprises a GaAs compound or consists of a GaAs compound,
- an n⁻ layer (14) with a first side, a second side opposite the first side, a doping substance concentration of 10¹² - 10¹⁸ N/cm⁸, a layer thickness (D2) of 10 - 300 microns, which layer comprises a GaAs compound or consists of a GaAs compound,
- a p⁺ layer (18) with a first side, a second side opposite the first side, a doping substance concentration of 5•10¹⁸ - 5•10²⁰ N/cm³, with a layer thickness (D3) greater than 2 microns, which layer comprises a GaAs compound or consists of a GaAs compound, wherein
- the layers follow one another in the stated sequence and are of monolithic construction,
- the n⁺ layer (12) or the p⁺ layer (18) is constructed as substrate and
- the second side of the n- layer (14) is connected by material couple with the first side of the n⁺ layer (12),
- arranged between the n⁻ layer (14) and the p⁺ layer (18) is a doped intermediate layer (15) with a layer thickness (D5) of 1 - 50 microns and a doping substance concentration of 10¹² - 10¹⁷ N/cm³ and with a first side and a second side opposite the first side, the second side of the intermediate layer (15) being connected with the first side of the n⁻ layer (14) by material couple and the first side of the intermediate layer being connected with the second side of the p⁺ layer (18) by material couple,
wherein the intermediate layer (15) is connected with the n⁻ layer and with the p⁺ layer (18) by material couple and is p-doped,
wherein the stack-shaped III-V semiconductor diode (10) has a first defect layer (16) with a layer thickness (D41) between 0.5 microns and 40 microns,
- wherein the defect layer (16) is arranged within the p-doped intermediate layer (15) and
- the defect layer (16) has a defect concentration in a range between 1•10¹³ N/cm³ and 5•10¹⁶ N/cm³.

2. III-V semiconductor diode (10) according to claim 1, **characterised in that** the first defect layer (16) has a spacing from the second side of the p-doped intermediate layer (15) of at least half the layer thickness (D5) of the p layer (15).

3. III-V semiconductor diode (10) according to claim 1 or 2, **characterised in that** the semiconductor diode (10) has a second defect layer (24), wherein the second deflect layer (24) has a layer thickness (D42) between 0.5 microns and 40 microns and a defect concentration between 1•10¹³ N/cm³ and 5•10¹⁶ N/cm³ and a spacing from the first side of the p-doped intermediate layer (15) of at most half the layer thickness (D5) of the p-doped intermediate layer (15).

4. III-V semiconductor diode (10) according to claim 1 or 2, **characterised in that** the first defect layer (16) and/or a second defect (24) has or each have a first layer region with a first defect concentration and a second layer region with a second defect concentration.

5. III-V semiconductor diode (10) according to claim 1 or 2, **characterised in that** the defect concentration over the layer thickness (D41, D42) of the first defect layer (16) and/or of a second defect layer (24) follows a statistical distribution.

6. III-V semiconductor diode (10) according to any one of claims 1 to 5, **characterised In that** the first defect layer (16) and/or the second defect layer (24) when present comprises or comprise Cr and/or indium and/or aluminium.

7. III-V semiconductor diode (10) according to any one of claims 1 to 6, **characterised in that** the overall height of a stack-shaped layer construction (100) consisting of the p⁺ layer (18), the n⁻ layer (14), the p-doped intermediate layer (15) and the n⁺ layer (12) is at most 150 - 800 microns.

8. III-V semiconductor diode (10) according to any one of claims 1 to 7, **characterised in that** the stack-shaped layer construction (100) consisting of the p⁺ layer (18), the n⁻ layer (14), the p-doped intermediate layer (15) and the n⁺ layer (12) has a rectangular or square surface with edge lengths (L1, L2) between 1 mm and 10 mm.

9. III-V semiconductor diode (10) according to any one of claims 1 to 7, **characterised in that** the stack-shaped layer construction (100) consisting of the p⁺ layer (18), the n⁻ layer (14), the p-doped intermediate layer (15) and the n⁺ layer (12) has a round, oval or circular surface.

## Revendications

1. Diode semi-conductrice III-V en forme de pile (10), présentant
- une couche n⁺ (12) avec un premier côté, un deuxième côté opposé au premier côté, une concentration en substances dopantes d'au moins 10¹⁹ N/cm³ et une épaisseur de couche (D1) de 50-675 µm, dans laquelle la couche n⁺ (12) comprend un composé GaAs ou se compose d'un composé GaAs,
- une couche n⁻ (14) avec un premier côté et un second côté opposé au premier côté, une concentration en substances dopantes de 10¹² - 10¹⁶ N/cm³, une épaisseur de couche (D2) de 10-300 µm et comprend un composé GaAs ou se compose d'un composé GaAs,
- une couche p⁺ (18) avec un premier côté, un second côté opposé au premier côté, une concentration en substances dopantes de 5^{∗}10¹⁸ - 5^{∗}10²⁰ N/cm³ et comprend un composé GaAs ou se compose d'un composé GaAs,
dans laquelle
- les couches se succèdent dans l'ordre indiqué et sont réalisées sous forme monolithique,
- la couche n⁺ (12) ou la couche p⁺ (18) sont réalisées comme substrat et
- le second côté de la couche n⁻ (14) est assemblé matériellement au premier côté de la couche n⁺ (12),
une couche intermédiaire dopée (15) avec une épaisseur de couche (D5) de 1-50 µm et une concentration en substances dopantes de 10¹² - 10¹⁷ N/cm³ est disposée entre la couche n⁻ (14) et la couche p⁺ (18), et avec un premier côté et un second côté opposé au premier côté, et le second côté de la couche intermédiaire (15) est assemblé matériellement au premier côté de la couche n⁻ (14) et le premier côté de la couche intermédiaire est assemblé matériellement au second côté de la couche p⁺ (18),
dans laquelle la couche intermédiaire (15) est assemblée matériellement à la couche n⁻ (14) et à la couche p⁺ (18) et est dopée p,
dans laquelle la diode semi-conductrice III-V en forme de pile (10) présente une première couche de défauts (16) avec une épaisseur de couche (D41) comprise entre 0,5 µm et 40 µm,
- dans laquelle la couche de défauts (16) est disposée à l'intérieur de la couche intermédiaire dopée p (15), et
- la couche de défauts (16) présente une concentration de défauts dans une plage comprise entre 1^{∗}10¹³ N/cm³ et 5^{∗}10¹⁶ N/cm³.

2. Diode semi-conductrice III-V (10) selon la revendication 1, **caractérisée en ce que** la première couche de défauts (16) présente une distance jusqu'au second côté de la couche intermédiaire dopée p (15) qui vaut au moins la moitié de l'épaisseur de couche (D5) de la couche p (15).

3. Diode semi-conductrice III-V (10) selon une revendication 1 ou 2, **caractérisée en ce que** la diode semi-conductrice (10) présente une seconde couche de défauts (24), dans laquelle la seconde couche de défauts (24) présente une épaisseur de couche (D42) comprise entre 0,5 µm et 40 µm et une concentration de défauts comprise entre 1^{∗}10¹³ N/cm³ et 5^{∗}10¹⁶ N/cm³ et présente une distance jusqu'au premier côté de la couche intermédiaire dopée p (15) valant au maximum la moitié de l'épaisseur de couche (D5) de la couche intermédiaire dopée p (15).

4. Diode semi-conductrice III-V (10) selon l'une quelconque des revendications 1 à 2, **caractérisée en ce que** la première couche de défauts (16) et/ou une seconde couche de défauts (24) présentent respectivement une première région de couche avec une première concentration de défauts et une seconde région de couche avec une seconde concentration de défauts.

5. Diode semi-conductrice III-V (10) selon l'une quelconque des revendications 1 à 2, **caractérisée en ce que** la concentration de défauts sur l'épaisseur de couche (D41, D42) de la première couche de défauts (16) et/ou d'une seconde couche de défauts (24) suit une distribution statistique.

6. Diode semi-conductrice III-V (10) selon l'une quelconque des revendications 1 à 5, **caractérisée en ce que** la première couche de défauts (16) et/ou la seconde couche de défauts (24), lorsque cette dernière est présente, comprend du Chrome et/ou de l'Indium et/ou de l'Aluminium.

7. Diode semi-conductrice III-V (10) selon l'une quelconque des revendications 1 à 6, **caractérisée en ce qu'**une hauteur totale d'une structure stratifiée en forme de pile (100) se composant de la couche p⁺ (18), de la couche n⁻ (14), de la couche intermédiaire dopée p (15) et de la couche n⁺ (12) vaut au maximum 150 - 800 µm.

8. Diode semi-conductrice III-V (10) selon l'une quelconque des revendications 1 à 7, **caractérisée en ce que** la structure stratifiée en forme de pile (100) se composant de la couche p⁺ (18), de la couche n⁻ (14), de la couche intermédiaire dopée p (15) et de la couche n⁺ (12) présente une surface rectangulaire ou carrée avec des longueurs de côté (L1, L2) comprises entre 1 mm et 10 mm.

9. Diode semi-conductrice III-V (10) selon l'une quelconque des revendications 1 à 7, **caractérisée en ce que** la structure stratifiée en forme de pile (100) se composant de la couche p⁺ (18), de la couche n⁻ (14), de la couche intermédiaire dopée p (15) et de la couche n⁺ (12) présente une surface ronde ou ovale ou circulaire.
